(19) Europäisches Patentamt
European Patent Office
Office européen des brevets

(11) **EP 2 872 908 B1**

(12) **EUROPÄISCHE PATENTSCHRIFT**

(45) Veröffentlichungstag und Bekanntmachung des Hinweises auf die Patenterteilung:
**10.06.2020   Patentblatt 2020/24**

(51) Int Cl.:
*G01R 31/36* (2020.01)      *G01R 31/367* (2019.01)

(21) Anmeldenummer: **13735202.7**

(86) Internationale Anmeldenummer:
**PCT/EP2013/002004**

(22) Anmeldetag: **08.07.2013**

(87) Internationale Veröffentlichungsnummer:
**WO 2014/009001 (16.01.2014 Gazette 2014/03)**

(54) **VERFAHREN ZUR BESTIMMUNG VON KENNGRÖSSEN EINES ENERGIESPEICHERS UND ENERGIESPEICHERSYSTEM**

METHOD FOR DETERMINING CHARACTERISTICS OF AN ENERGY STORE AND ENERGY STORAGE SYSTEM

PROCÉDÉ POUR DÉTERMINER DES GRANDEURS CARACTÉRISTIQUES D'UN ACCUMULATEUR D'ÉNERGIE ET SYSTÈME ACCUMULATEUR D'ÉNERGIE ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.07.2012   DE 102012013739**

(43) Veröffentlichungstag der Anmeldung:
**20.05.2015   Patentblatt 2015/21**

(73) Patentinhaber: SEW-EURODRIVE GmbH & Co. KG
76646 Bruchsal (DE)

(72) Erfinder:
• HAUCK, Matthias
  68723 Schwetzingen (DE)
• LAMPERT, Christian
  76646 Bruchsal (DE)
• SCHIFFMANN, Sebastian
  76709 Kronau (DE)
• SCHMIDT, Josef
  76676 Graben-Neudorf (DE)
• TRITSCHLER, Daniel
  76646 Bruchsal (DE)
• WEBER, Jochen
  68726 Plankstadt (DE)
• ZÖLLER, Thomas
  76646 Bruchsal (DE)

(56) Entgegenhaltungen:
EP-A1- 2 063 280          EP-A2- 1 480 051
WO-A1-2011/102472         WO-A2-2012/156233
DE-A1- 10 301 823         DE-A1- 19 959 019
DE-A1-102009 046 500      US-A1- 2013 158 916

• HONGWEN HE ET AL: "Online estimation of model parameters and state-of-charge of LiFePObatteries in electric vehicles", APPLIED ENERGY, ELSEVIER SCIENCE PUBLISHERS, GB, Bd. 89, Nr. 1, 3. August 2011 (2011-08-03) , Seiten 413-420, XP028301813, ISSN: 0306-2619, DOI: 10.1016/J.APENERGY.2011.08.005 [gefunden am 2011-08-09]
• XIAOSONG HU ET AL: "Online estimation of an electric vehicle Lithium-Ion battery using recursive least squares with forgetting", 2011 AMERICAN CONTROL CONFERENCE (ACC 2011) : SAN FRANCISCO, CALIFORNIA, USA, 29 JUNE - 1 JULY 2011, IEEE, PISCATAWAY, NJ, 29. Juni 2011 (2011-06-29), Seiten 935-940, XP032034981, ISBN: 978-1-4577-0080-4

EP 2 872 908 B1

**Beschreibung**

Die Erfindung betrifft ein Verfahren zur Bestimmung von Kenngrößen eines Energiespeichers und ein Energiespeichersystem.

Die Patentschrift DE 10 2011 119 005 beschreibt ein Verfahren zur Ermittlung des Innenwiderstandes bzw. der Temperatur in einem Zellverbund von Batterien in Fahrzeugen. Jedoch werden auch hier relativ hohe Anforderungen an den Messzyklus gestellt.

Aus der DE 103 01 823 A1 ist ein Verfahren zum Ermitteln der aus einem Energiespeicher entnehmbaren Ladung bekannt.

Aus der DE 199 59 019 A1 ist ein Verfahren zur Zustandserkennung eines Energiespeichers bekannt.

Aus der WO 2011/102472 A1 ist ein Verfahren zur Schätzung des Batteriezustandes bekannt.

Aus der EP 2 063 280 A1 ist ebenfalls ein Verfahren zur Schätzung des Batteriezustandes bekannt.

Aus der DE 10 2009 046 500 A1 ist ein Verfahren zur Bestimmung des Innenwiderstandes einer Batterie bekannt.

Aus der EP 1 480 051 A2 ist ein Verfahren zur Bestimmung der Hochstrombelastbarkeit einer Batterie bekannt.

Aus der US 2013/0158916 A1 ist ein Verfahren zur Schätzung der Batterieladung bekannt.

Aus der WO 2012/156233 A2 ist ein Verfahren zum Bestimmen eines Zustandsparameters einer Batterie bekannt.

Der Erfindung liegt daher die Aufgabe zugrunde, ein Verfahren zur Bestimmung von Kenngrößen eines Energiespeichers weiterzubilden.

Erfindungsgemäß wird die Aufgabe bei dem Verfahren nach den in Anspruch 1 und bei dem Energiespeichersystem nach den in Anspruch 9 angegebenen Merkmalen gelöst.

Wichtige Merkmale der Erfindung bei dem Verfahren sind, dass das Verfahren zur Bestimmung von Kenngrößen eines Energiespeichers vorgesehen ist,

wobei Ausgangsstrom und Ausgangsspannung des Energiespeichers erfasst werden, insbesondere also erfasste Größen sind,

wobei eine erste der beiden erfassten Größen einem Streckenmodell zugeführt wird,

die zweite der beiden erfassten Größen einer Reglerstruktur zugeführt wird,

wobei das Streckenmodell einen Modellwert für die zweite Größe erzeugt und dieser Modellwert der Reglerstruktur zugeführt wird,

wobei die Reglerstruktur Schätzwerte der Kenngrößen bestimmt, welche dem Streckenmodell vorgegeben werden.

Von Vorteil ist dabei, dass die Bestimmung der Kenngrößen des Energiespeichers im Betrieb erfolgt und dabei keine Beeinflussung des Energiespeichers beziehungsweise des Ladestroms oder Entladestroms und/oder der Ausgangsspannung am Energiespeicher für die Bestimmung der Kenngrößen stattfindet. Somit ist also die Bestimmung online im laufenden Betrieb ermöglicht, insbesondere wobei Zeitabschnitte besonders genutzt werden, in denen der Strom sich systembedingt stark ändert.

Das Verfahren ermöglicht auf diese Weise auch eine Kurzschlusserkennung, indem die bestimmte Kapazität des Energiespeichers auf das Überschreiten eines vorgegebenen maximalen Wertes überwacht wird. Außerdem ist eine alterungsabhängige und von der Ladeenergie abhängige Bestimmung der Sollladespannung ermöglicht. Außerdem ist ein Vergleich der aus den erfassten Messwerten bestimmten Kenngrößenwerte mit den erwarteten Kenngrößenwerten ausführbar, wobei die erwarteten Kenngrößenwerte Nennwerte des anzuschließenden Energiespeichers sind. Ist also fehlerhafterweise ein anderer Energiespeicher angeschlossen ist dies erkennbar. Alternativ ist mit der Bestimmung der Kenngrößenwerte auch die Bestimmung des angeschlossenen Energiespeichers ermöglicht, wenn ein Baukasten oder eine Menge von Energiespeichern bekannt ist, die anschließbar sind. Aus einer bekannten Menge mit bekannten Kenngrößenwerten ist also durch die Bestimmung der Kenngrößenwerte eine Bestimmung des angeschlossenen Energiespeichers ermöglicht.

Erfindungsgemäß wird in der Reglerstruktur die Abweichung, insbesondere Differenz, zwischen Modellwert für die zweite Größe und erfasstem Wert der zweiten Größe bestimmt und die Schätzwerte der Kenngrößen werden als Ausgangssignal und/oder Stellwerte der Reglerstruktur bestimmt, abhängig vom zeitlichen Verlauf der Abweichung und des zeitlichen Verlaufs der zweiten Größe. Von Vorteil ist dabei, dass die Reglerstruktur die Kenngrößenwerte auf einen derartigen Wert hinregelt, dass die Abweichung verschwindet.

Erfindungsgemäß ist jeder Bestimmung einer Kenngröße ein jeweiliger von den anderen Pfaden unterschiedlicher und unabhängiger Pfad zugeordnet,

wobei der zeitliche Verlauf der Abweichung und der zeitliche Verlauf der zweiten Größe jedem Pfad zugeführt wird. Von Vorteil ist dabei, dass in der Reglerstruktur jede Kenngröße unabhängig voneinander bestimmt wird.

Bei einer vorteilhaften Ausgestaltung beschreibt das Streckenmodell ein Ersatzschaltbild für den Energiespeicher,

wobei die von der Reglerstruktur bestimmten Schätzwerte der Kenngrößen die das Ersatzschaltbild kennzeichnenden Kenngrößen sind,

insbesondere bei einem kapazitiven Energiespeicher (z. B. Doppelschichtkondensatoren) ein Ersatzschaltbild für ein RC-Glied, wobei C die Kapazität $C_{ges}$ des Energiespeichers und R der Innenwiderstand $R_{ges}$ des Energiespeichers ist. Von Vorteil ist dabei, dass eine Modellierung des kapazitiven Energiespeichersystems in einfacher Weise ausführbar ist. In erster

Näherung wird nur ein RC-Glied als Modell für den kapazitiven Energiespeicher angewendet. Die Erfindung ist aber auch bei besseren Näherungen ausführbar in entsprechender Weise.

Bei einer vorteilhaften Ausgestaltung wird zur Bestimmung der Kapazität $C_{ges}$

- die Abweichung multipliziert mit dem Vorzeichensignal der erfassten zweiten Größe und
- das Produkt integriert, um den Schätzwert für die Kapazität $C_{ges}$ zu erhalten.

Von Vorteil ist dabei, dass ein besonders schnelles Hinregeln der Kenngrößenwerte auf ihren Idealwert ausführbar ist, bei dem die Abweichung verschwindet.

Bei einer vorteilhaften Ausgestaltung weist zur Bestimmung des Gesamtwiderstandes $R_{ges}$,

- nur wenn die zeitliche Ableitung des erfassten Stromverlaufs einen Mindestwert überschreitet, die Abweichung multipliziert wird mit dem Vorzeichensignal der zeitliche Ableitung des erfassten Stromverlaufs und
- das Produkt integriert wird, um den Schätzwert für des Gesamtwiderstand $R_{ges}$ zu erhalten.

Von Vorteil ist dabei, dass Zeitabschnitte, in denen schnelle Stromänderungen auftreten, verwendet werden, um einen aktualisierten Kenngrößenwert zu bestimmen. Bei langsamen Stromveränderungen wird keine Aktualisierung ausgeführt, da die dabei großen relativen Messfehler große Ungenauigkeiten bewirken könnten.

Bei einer vorteilhaften Ausgestaltung wird der zeitliche Verlauf der Werte einer oder beider erfassten Größen tiefpassgefiltert, insbesondere wobei die zeitliche Ableitung aus dem tiefpassgefilterten Signal bestimmt wird. Von Vorteil ist dabei, dass weniger große Diracpulse in dem zeitlich abgeleiteten, also differenziertem, Signal auftreten und/oder überlagert sind.

Bei einer vorteilhaften Ausgestaltung wird im Streckenmodell der Schätzwert der zweiten Größe integriert und außerdem durch beide Kenngrößen dividiert, insbesondere also wird der Schätzwert durch das Produkt der beiden Kenngrößen dividiert. Von Vorteil ist dabei, dass ein schnelles Hinregeln auf den Idealwert ausführbar ist.

Bei einer vorteilhaften Ausgestaltung wird die Abweichung einem Begrenzer zugeführt. Von Vorteil ist dabei, dass der Arbeitsbereich vorgebbar ist.

Bei einer vorteilhaften Ausgestaltung ist die erste Größe der erfasste Strom und die zweite Größe die erfasste Spannung oder umgekehrt. Von Vorteil ist dabei, dass aus in einfacher Weise erfassten Größen die Regelstruktur die Kenngrößenwerte bestimmt.

Wichtige Merkmale bei dem Verfahren zur Bestimmung von Kenngrößen eines Energiespeichers sind, dass

Ausgangsstrom und Ausgangsspannung des Energiespeichers erfasst werden, insbesondere also erfasste Größen sind,

wobei die beiden erfassten Größen einem Filter zugeführt werden, dessen Ausgangssignal Schätzwerte der Kenngrößen sind,

wobei dem Filter ein Wert zur Bewertung des Messrauschens der ersten Größe und ein Wert zur Bewertung des Messrauschens der zweiten Größe zugeführt wird,

wobei dem Filter ein Wert zur Bewertung des Sytemrauschens zugeführt wird.

Von Vorteil ist dabei, dass eine Online-Bestimmung der Kenngrößenwerte ohne Beeinflussung des Systems ausführbar ist.

Bei einer vorteilhaften Ausgestaltung ist das Filter ein Kalman-Filter und/oder

ein Streckenmodell wird in linearer Näherung um den durch die Werte der Kenngrößen gekennzeichneten Arbeitspunkt herum verwendet. Von Vorteil ist dabei, dass ein Standardverfahren anwendbar ist, wobei die Verwendung eines Kalman-Filters für die Bestimmung der Kenngrößen eines Energiespeichers nicht nur neu ist sondern besonders gute Ergebnisse erzielen lässt.

Wichtige Merkmale bei dem Energiespeichersystem zur Durchführung eines vorgenannten Verfahrens sind, dass Mittel zur Erfassung des Ausgangsstroms und der Ausgangsspannung an einem Energiespeicher vorgesehen sind, so dass die erfassten Größen einer Reglerstruktur und einem Streckenmodell zuführbar sind,

insbesondere wobei der Energiespeicher aus Kondensatoren zusammengesetzt ist, die in Reihe und/oder parallel miteinander verschaltet sind. Vorteiligerweise ist somit eine Überwachung des Energiespeichers, insbesondere auch ein Monitoring seiner Alterung, in einfacher Weise ausführbar.

Weitere Vorteile ergeben sich aus den Unteransprüchen. Die Erfindung ist durch den Gegenstand der Patentansprüche definiert.

Die Erfindung wird nun anhand von Abbildungen näher erläutert:

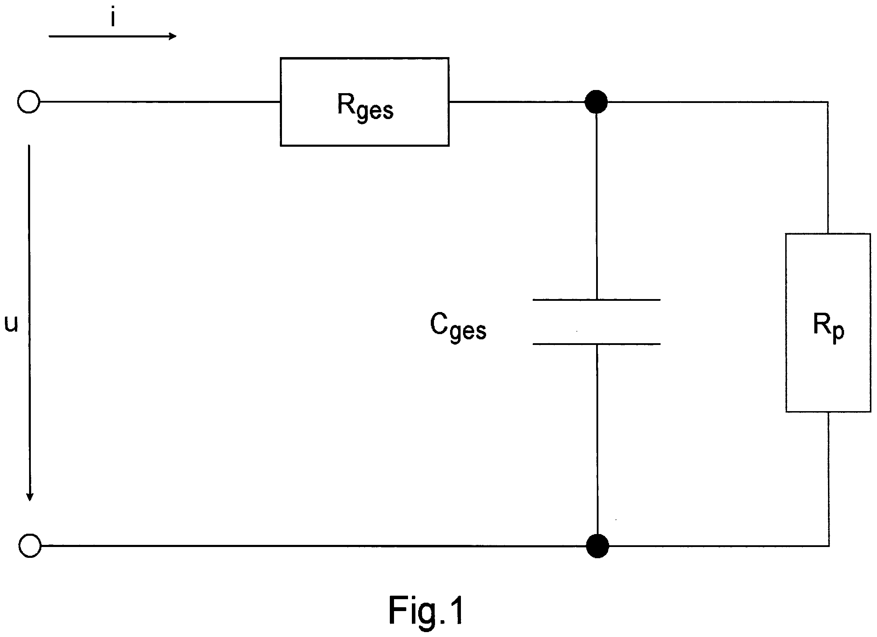

In der Figur 1 ist ein elektrisches Ersatzschaltbild für den Energiespeicher gezeigt.

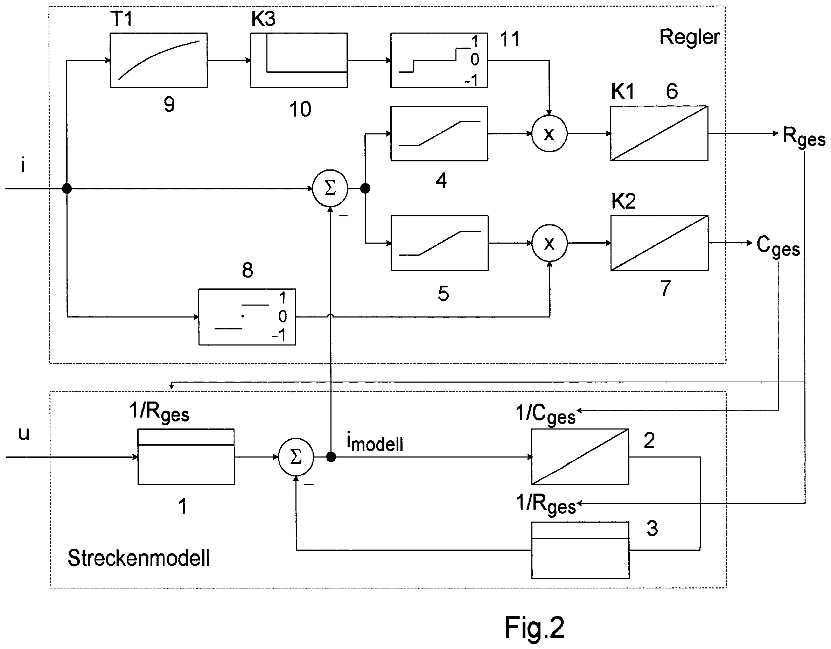

In der Figur 2 ist ein erfindungsgemäßes Regelsystem gezeigt, welches im laufenden Betrieb aus erfassten Stromverläufen und Spannungsverläufen die Parameter des Energiespeichers bestimmt. Hierbei wird die erfasste Ausgangsspannung u(t) am Energiespeicher als Eingangsgröße einem im unteren Teil der Figur 2 gezeigten Streckenmodell, welches ein RC-Glied modelliert, zugeleitet. Der berechnete Strom im Streckenmodell $i_{modell}(t)$ wird einer im oberen Teil der Figur 2 gezeigten Reglerstruktur als Istgröße vorgegeben. Die Sollgröße der Reglerstruktur ist der erfasste Ausgangsstrom i(t) des Energiespeichers. Das Differenzsignal, also die Regelabweichung, dient zwei Berechnungspfaden als Eingang. Im zweiten Berechnungspfad wird die Kapazität $C_{ges}$ bestimmt, indem die begrenzte Regelabweichung in Abhängigkeit des Vorzeichens des erfassten Stromes integriert wird. Im ersten Berechnungspfad, in welchem die Berechnung des Innenwiderstandes $R_{ges}$ vorgesehen ist, erfolgt nur eine Integration der Regeldifferenz, falls die zeitliche Ableitung des erfassten Stromes einen vorgegebene Mindestbetrag überschritten hat. Die berechneten Größe $R_{ges}$ und $C_{ges}$ werden direkt ins Streckenmodell, also den unteren Teil der Figur 2, rückgekoppelt.

Der Energiespeicher ist von einem Energiespeichersystem umfasst, das aus dem Energiespeicher und einem Energiespeicherstromrichter besteht, welcher eine Leistungs- und Kommunikationsschnittstelle für ein weiteres Systems, beispielsweise umrichtergespeister Elektromotor oder anderes elektrisches Antriebssystem, aufweist. Somit ist Energie aus dem weiteren System vom Energiespeichersystem aufnehmbar oder an das weitere System Energie abgebbar.

Der Energiespeicherstromrichter weist auch Mittel zur Erfassung des Eingangsstroms in den Energiespeicher beziehungsweise Ausgangsstroms aus dem Energiespeicher auf.

Der Energiespeicher weist eine Zusammenschaltung, insbesondere Reihenschaltung oder Parallelschaltung von Einzelzellen, insbesondere Kondensatoren, auf.

Jede Einzelzelle weist eine Kapazität $C_Z$ und einen Innenwiderstand $R_Z$ auf. In erster Näherung ist das elektrische Ersatzschaltbild des Energiespeichers mittels Figur 1 beschreibbar, wobei eine Gesamt-Kapazität $C_{ges}$ und ein Innenwiderstand $R_{ges}$ den Energiespeicher kennzeichnen. Ein parallel zur Gesamt-Kapazität vorhandener Verlustwiderstand $R_P$ wird im Folgenden vernachlässigt.

Wie oben erwähnt, werden Ausgangsspannung und Ausgangsstrom des Energiespeichers erfasst, so dass der zeitlich zumindest diskrete Verlauf dieser Messgrößen u(t) und i(t) einem Rechner, insbesondere Mikrocontroller, des Energiespeicherstromrichters zur Verfügung steht.

Mittels des Rechners wird aus diesen erfassten Größen im Betrieb, also ohne Störung oder sonstige Beeinflussung der Lade- und Entladevorgänge des Energiespeichers, die Gesamt-Kapazität $C_{ges}$ und der Innenwiderstand $R_{ges}$ bestimmt. Dabei sind die Spannung u(t) und der Strom i(t) Eingangssignale eines im Rechner realisierten Regelsystems.

Aus den bestimmten Werten beziehungsweise zeitlichen Verläufen der Gesamt-Kapazität $C_{ges}$ und des Innenwiderstands $R_{ges}$ ist eine Zustandsbestimmung ausführbar, also ein Bestimmen eines Alterungswertes oder ein Bestimmen einer Restnutzungsdauer, wobei vorzugsweise hinterlegte Kennlinienfelder verwendet werden.

Infolge der unter anderem spannungsabhängigen und temperaturabhängigen Alterung verringert sich nämlich die Kapazität des Energiespeichers und erhöht sich der Innenwiderstand. Somit ist eine effiziente Betriebsführung des Gesamtsystems ausführbar und ein rechtzeitiger Austausch des Energiespeichers an dessen Lebensdauerende ist einplanbar.

Außerdem ist eine Überwachung des Energiespeichers des Energiespeichersystems ausführbar. Insbesondere Kurzschlüsse in den Anschlussleitungen oder einzelne Zellenkurzschlüsse sind in einfacher Weise und im Wesentlichen fehlerfrei erkennbar. Dies ist besonders wichtig für das Betreiben des Energiespeicherstromrichters

Darüber hinaus ist aber auch zusätzlich oder alternativ eine Parametrierung des Energiespeicherstromrichters ausführbar, da diesem möglichst bei der Inbetriebnahme des Energiespeichersystems zumindest der Arbeitsspannungsbereich und die Kapazität des Energiespeichers bekannt gemacht sein muss. Eine Fehlparametrierung kann zu einer Zerstörung des Speichers führen. Erfindungsgemäß wird eine Bestimmung der Parameter im Betrieb, also eine automatische Erkennung des Energiespeichers, insbesondere dessen Größe und Spannungsbereich, ausgeführt und der Energiespeicherstromrichter somit optimal parametrierbar. Insbesondere werden die Gesamt-Kapazität $C_{ges}$ und der Innenwiderstand $R_{ges}$ laufend bestimmt und aktualisiert.

Die Ladezyklen und Entladezyklen des Energiespeichersystems sind vorzugsweise zwischen einer Sekunde und einer Stunde. Die im Energiespeicher maximal speicherbare Energiemenge liegt im Bereich von 10 kWs bis 1000 kWs, insbesondere sind dabei Spannungen zwischen 10V und 1000 V vom Energiespeicher bereitstellbar. Somit sind als Antriebe industrieübliche Antriebe mit einer Nennleistung zwischen 0,5 kW bis 100kW und mehr aus dem Energiespeicher zeitweise versorgbar. Besonders vorteilig ist der Einsatz des Energiespeichers bei Hubwerkanwendungen oder Regalbediengeräten, bei denen beim Absenken einer Last vom Antrieb eine sehr hohe generatorische Leistung erzeugt wird. Mittels des Energiespeichers sind sogar Netzrückspeisegeräte einsparbar, so dass die generatorisch erzeugte Energie dem Zwischenkreis des Antriebsumrichters entnehmbar ist und dem Energiespeicher zuführbar ist. Bei nachfolgend motorischem Betrieb des Antriebs, also beispielsweise Heben einer Last ist aus dem Energiespeicher wiederum Energie in den Zwischenkreis des Antriebs einspeisbar und somit der Antrieb auf diese Weise versorgbar.

Ebenfalls vorteilig ist der Einsatz dieses Energiespeichers bei Anwendungen mit hohen Beschleunigungen und Verzögerungen, wie beispielsweise Handlingsmaschinen, Roboter oder Querverschiebewagen. Ebenfalls sinnvoll ist der Einsatz bei mobilen Anwendungen z.B. fahrerlosen Transportsystemen

Für die zeitliche Ableitung des Spannungsverlaufs u' zu einem Zeitpunkt gilt folgender mathematischer Zusammenhang:

$$u' = R_{ges} \cdot i' + \frac{1}{C_{ges}} \cdot i,$$

wobei i der erfasst Strom zum Zeitpunkt und i' dessen zeitliche Ableitung ist.

Somit gilt:

$$C_{ges} = \frac{i}{u' - R_{ges} \cdot i'}$$

$$R_{ges} = \frac{u' - \frac{1}{C_{ges}} \cdot i}{i'}$$

Bei einer Speicher-Auf- bzw. -Entladung mit konstantem Strom bzw. konstanter Leistung kann in vielen Fällen die Ableitung des Stromes gegenüber der Ableitung der Spannung vernachlässigt werden. Hierdurch wird die Berechnung des Speichers unabhängig vom Innenwiderstand und das Gleichungssystem entkoppelt:

$$C_{ges} = \frac{i}{u'}$$

Zur Berechnung des Innenwiderstandes $R_{ges}$ wird dagegen ein Mindeststromgradient benötigt.

Die erfindungsgemäße Kurzschlussüberwachung ermöglicht die Unterscheidung eines nicht geladenen Speichers von einem Kurzschluss.

Mittels der erfindungsgemäß automatischen Parametrierung ist die Fehleranfälligkeit verringerbar.

Bei der erfindungsgemäßen Bestimmung der Parameter, also der Kapazität $C_{ges}$ und des Innenwiderstandes $R_{ges}$ des Speichers ist eine Zustandsbestimmung während des regelmäßigen Betriebs, also der regulären Benutzung, des Energiespeichers ausführbar, wobei also die Applikation den Leistungsaustausch mit dem Energiespeicher, insbesondere unvorhersehbar, vorgibt. Der Rechner muss also keine weiteren Informationen über den Betrieb oder die Ladezyklen erhalten, insbesondere keine Synchronisationssignale, Triggersignale oder dergleichen. Erfindungsgemäß werden keine Testbelastungen für den Energiespeicher zur Bestimmung der Parameter angewendet und/oder entsprechende Betriebsunterbrechungen vorgesehen.

Nach Bestimmung der Kapazität $C_{ges}$ und des Innenwiderstandes $R_{ges}$ und dem somit bekannten zeitlichem Verlauf der Werte dieser Größen wird der Alterungsgrad des Speichers und somit die Restlebensdauer unter der Voraussetzung unveränderter Nutzungsbedingungen durch Vergleich mit zuvor bestimmten, im Speicher des Rechners hinterlegten Alterungskurven, abgeleitet.

Darüber hinaus wird die aktuell gespeicherte Energie bestimmt und entsprechend dem Bedarf geregelt. Bezüglich der Alterung bedeutet dies, dass bei gleichem Sollwert der eingespeicherten Energie, welcher von einer übergeordneten Steuerung oder vom Antrieb vorgegeben wird, beispielsweise bezogen auf einen Energiebedarf für einen ein- bis vierzigminütigen Betrieb des Antriebsmotors eines fahrerlosen Transportsystems, Regalbediengeräts oder dergleichen, die Restnutzungsdauer des Energiespeichers abschätzbar ist, wobei entsprechende Kennlinien verwendet werden zur Bestimmung der Restnutzungsdauer aus den bestimmten zeitlichen Verläufen der Parameter $R_{ges}$ und $C_{ges}$ des Energiespeichers. Eine entsprechend zugehörige, an die aktuelle Speicherkapazität angepasste Sollladespannung ist vorgebbar.

Tritt während des Betriebes des Energiespeichersystems ein Kurzschluss auf oder kommt es zu Zellenkurzschlüssen, wird dies durch die erfindungsgemäße Online-Bestimmung detektierbar, indem erkannt wird, dass der Parameter $C_{ges}$ einen kritischen Wert überschreitet und/oder der Kapazitätswert einen positiven Gradienten aufweist, also mit der Zeit zunimmt.

Darüber hinaus kann auch überwacht werden, ob ein zu den Parametern unpassender Energiespeicher angeschlossen ist. Denn bei Montage könnte ein zu den gewünschten Parametern unpassender Energiespeicher angeschlossen werden oder bei Inbetriebnahme könnten zum angeschlossenen Energiespeicher unpassende Parameter eingegeben worden sein. Wenn durch die erfindungsgemäße Bestimmung eine zu große Abweichung festgestellt wird, wird eine Warnungsmeldung herausgegeben oder ein Abschalten des Systems bewirkt.

Sind alle aus einem Baukasten anschließbaren Varianten von Energiespeichern bekannt, ist auf Basis der ermittelten Kenngrößen $C_{ges}$ und $R_{ges}$ die angeschlossene Variante und damit deren Spannungsbereich bestimmbar. Die durch den Anwender durchgeführte Parametrierung ist auf diese Weise sogar verzichtbar. Eine Fehlparametrierung, insbesondere bezüglich der maximalen Spannung, ist nicht mehr möglich.

Durch die erfindungsgemäße Methode ist auch ein Überladungsschutz, also ein Schutz gegen Überspannung, realisierbar, indem der Rechner überprüft, ob der Arbeitsspannungsbereich überschritten wird oder nicht.

Bestimmung der Kapazität $C_{ges}$ und des Innenwiderstandes $R_{ges}$

Bei einem ersten erfindungsgemäßen Ausführungsbeispiel wird die Online-Bestimmung der Kapazität und des Innenwiderstandes folgendermaßen ausgeführt:

Hierzu zeigt Figur 2 ein Strukturbild des erfindungsgemäßen Regelsystems.

Im unteren Teil ist ein geregeltes Streckenmodell als Reglerstruktur gezeigt, wobei hier ein regelungstechnisches Abbild der Figur 1 bei vernachlässigtem Verlustwiderstand ausgeführt ist. Eingangssignal ist die erfasste Spannung.

Im oberen Teil der Figur 2 ist eine Reglerstruktur gezeigt, welcher der im Streckenmodell als Schätzwert bestimmte Strom $i_{modell}$, also ein Modellwert für den Strom, zugeführt wird. Außerdem werden von der Reglerstruktur Schätzungswerte, also Modellwerte, für die Kapazität $C_{ges}$ und den Innenwiderstand $R_{ges}$ bestimmt und dem Streckenmodell im unteren Teil der Figur 2 zugeleitet als Parameter.

Beim Streckenmodell wird die als Eingangssignal verwendete, am Energiespeicher erfasste Spannung u über ein Proportionalglied 1 einem Differenzbildner zugeführt, welcher die Abweichung zu einem Stromwert bestimmt und diese Abweichung als Modellwert $i_{modell}$ für den Ausgangsstrom des Energiespeichers erzeugt. Der Spannungswert wird durch Integration des Modellwerts $i_{modell}$ mittels des Integrierglieds 2 bestimmt, wobei durch die von der Reglerstruktur bestimmten Werte für Kapazität $C_{ges}$ und Innenwiderstand $R_{ges}$ dividiert wird, wie an dem Integrierglied 2, das auch die Division durch den Kapazitätswert $C_{ges}$ ausführt, und dem Proportionalglied 3 ersichtlich.

Der Reglerstruktur im oberen Teil der Figur 2 wird der erfasste Strom i und der von dem Streckenmodell gebildete Modellwert $i_{modell}$ zugeführt. Ein Differenzbildner bildet wiederum die Abweichung, aus welcher mittels der Reglerstruktur die Parameter bestimmt werden. Hierzu wird die Abweichung zwei Pfaden zugeführt, wobei der erste Pfad der Bestimmung der Kapazität $C_{ges}$ und der zweite Pfad der Bestimmung des Innenwiderstandes $R_{ges}$ dient.

Im ersten Pfad wird zunächst ein Begrenzer 4 wirksam, dessen Ausgangssignal einem Multiplizierer zugeführt wird, der multipliziert mit dem über den Tiefpass 9, nachfolgend über das Differenzierglied 10 und das Konditionalglied 11 geleiteten Stromsignal i. Somit wird das Ausgangssignal des Begrenzers 4 multipliziert mit der Konditionalfunktion des Konditionalglieds 11 des tiefpassgefilterten differenzierten Stromsignals i.

Dabei ist die Konditionalfunktion Null, solange der Betrag des Eingangssignals am Konditionalglied 11 kleiner als ein vorgegebener Wert, insbesondere Mindestwert, ist. Andernfalls, also bei betragsmäßiger Überschreitung des vorgegebenen Wertes, insbesondere Mindestwertes, ist das Ausgangssignal des Konditionalglieds nicht Null sondern gleich dem Vorzeichen des an seinem Eingang anliegenden Eingangssignals, also +1 oder -1.

Das Konditionalglied 11 wäre auch als Doppelkomparator oder Dreipunktkomparator bezeichenbar.

Das Ausgangssignal des Multiplizierers, also das Produkt der Multiplikation, wird einem Integrierglied 6 zugeführt, an dessen Ausgang der Schätzwert für den Gesamtwiderstand $R_{ges}$ anliegt.

Im zweiten Pfad wird zunächst ein Begrenzer 5 wirksam, dessen Ausgangssignal einem Multiplizierer zugeführt wird, der multipliziert mit dem über ein Signumglied 8 geleiteten Stromsignal i. Somit wird also multipliziert mit der Signumfunktion des Stromsignals.

Dabei ist die Signumfunktion Null, wenn das Eingangssignal verschwindet. Andernfalls, also bei Nicht-Verschwinden des Eingangssignals ist das Ausgangssignal des Signumglieds nicht Null sondern gleicht dem Vorzeichen des an seinem Eingang anliegenden Eingangssignals, also +1 oder -1.

Vorzugsweise wird die Integration von $C_{ges}$ unterbunden, falls $R_{ges}$ integriert wird.

Das Signumglied 8 wäre auch als Doppelkomparator oder Dreipunktkomparator bezeichenbar.

Das Ausgangssignal des Multiplizierers, also das Produkt der Multiplikation, wird einem Integrierglied 7 zugeführt, an dessen Ausgang der Schätzwert für die Kapazität $C_{ges}$ anliegt. Somit wird also in der Reglerstruktur aus der Stromabweichung des geschätzten Stromwertes vom erfassten Stromwert das Vorzeichensignal des erfassten Stromes aufmultipliziert, um nach Integration den Schätzwert für die Kapazität $C_{ges}$ zu erhalten. Auf diese Weise wird die Bestimmung der Kapazität $C_{ges}$ ständig aktualisiert, insbesondere im Takt der Software des digital ausgeführten Rechners. Ein Takt beträgt beispielsweise zwischen 0,1ms und 20ms.

Zur Bestimmung des Gesamtwiderstandes $R_{ges}$ wird infolge der Konditionalfunktion nur dann eine aktualisierte Bestimmung des Schätzwertes für den Gesamtwiderstand $R_{ges}$ vorgenommen, wenn die zeitliche Ableitung des erfassten Stromverlaufs einen Mindestwert überschreitet, also eine schnelle Stromänderung auftritt. Bei Konstantstrom-Ladung oder Entladung wird also der Gesamtwiderstand $R_{ges}$ nicht aktualisiert. Nur bei sprunghaften Stromänderungen, wie beispielsweise beim Beginn eines Ladezyklus oder Entladezyklus, wird also der Gesamtwiderstand $R_{ges}$ aktualisiert. Wenn die Zyklen häufig beginnen, wird also entsprechend oft aktualisiert.

Wenn die Aktualisierung ausgeführt wird, wird der erfasste Stromwert mit dem Vorzeichensignal des zeitlich abgeleiteten, also differenzierten, erfassten Stromes aufmultipliziert, um nach Integration den Schätzwert für die Kapazität $R_{ges}$ zu erhalten.

Der Tiefpass mit Zeitkonstante T1 ist daher notwendig, weil die diskrete Stromerfassung nicht kontinuierlich erfolgt sondern zeitdiskret und daher die direkte Differenzierung dieses diskreten Signals hohe Dirac-Pulse aufweist. Außerdem wird auch das Messrauschen unterdrückt.

Die Begrenzer begrenzen auf den Arbeitsbereich, also Strombereich, welcher nur innerhalb der zulässigen Werte sein darf.

Mittels einer zusätzlichen Überwachung der Regelabweichung sind transiente Fehlerereignisse detektierbar.

Bei anderen erfindungsgemäßen Ausführungsbeispielen wird ein Kalman-Filter verwendet, dem die erfassten Stromwerte i(t) und Spannungswerte u(t) zugeführt werden, wobei als Ausgangssignale des Kalman-Filters die Kapazität $C_{ges}$ und der Innenwiderstand $R_{ges}$ erzeugt werden. Das Kalman-Filter löst dabei das Problem der Zustandsschätzung eines linearen, zeitdiskreten, stochastischen Systems und ist somit auch zur Bestimmung der Parameter, insbesondere Kapazität $C_{ges}$ und Innenwiderstand $R_{ges}$, des Energiespeichers anwendbar. Das Streckenmodell, also RC-Glied-Modellierung, muss dazu um einen Arbeitspunkt von $R_{ges}$ und $C_{ges}$ linearisiert werden und Werte erhalten, welche das Messrauschen und das Systemrauschen beschreiben.

Bezugszeichenliste

$C_{ges}$ Gesamt-Kapazität des Energiespeichers
$R_{ges}$ Innenwiderstand
$R_p$ Verlustwiderstand
u Ausgangsspannung am Energiespeicher
i Ausgangsstrom des Energiespeichers

1 Divisorglied
2 Integrierglied
3 Integrierglied
4 Begrenzer
5 Begrenzer
6 Integrierglied
7 Integrierglied
8 Signumglied
9 Tiefpass mit Zeitkonstante T1
10 Differenzierglied
11 Konditionalglied

**Patentansprüche**

1. Verfahren zur Bestimmung von Kenngrößen eines Energiespeichers,
wobei Ausgangsstrom (i) rund Ausgangsspannung (u) er des Energiespeichers erfasst werden, also erfasste Größen sind,
wobei eine erste der beiden erfassten Größen einem Streckenmodell zugeführt wird,
die zweite der beiden erfassten Größen einer Reglerstruktur zugeführt wird,
wobei das Streckenmodell einen Modellwert für die zweite Größe erzeugt und dieser Modellwert der Reglerstruktur zugeführt wird,
wobei die Reglerstruktur Schätzwerte der Kenngrößen bestimmt, welche dem Streckenmodell vorgegeben werden, und
wobei in der Reglerstruktur die Abweichung zwischen Modellwert für die zweite Größe und erfasstem Wert der zweiten Größe bestimmt wird und die Reglerstruktur die Kenngrößenwerte jeweils auf einen derartigen Wert hinregelt, dass die Abweichung verschwindet, **dadurch gekennzeichnet, dass**
in der Reglerstruktur die Abweichung zwischen Modellwert für die zweite Größe und erfasstem Wert der zweiten Größe bestimmt wird und die Schätzwerte der Kenngrößen als Ausgangssignal und/oder Stellwerte der Reglerstruktur bestimmt werden abhängig vom zeitlichen Verlauf der Abweichung und des zeitlichen Verlaufs der zweiten Größe,
wobei jeder Bestimmung einer Kenngröße ein jeweiliger von den anderen Pfaden unterschiedlicher und unabhängiger Pfad zugeordnet ist, und wobei der zeitliche Verlauf der Abweichung und der zeitliche Verlauf der zweiten Größe jedem Pfad zugeführt wird.

2. Verfahren nach Anspruch 1,
**dadurch gekennzeichnet, dass**
das Streckenmodell ein Ersatzschaltbild für den Energiespeicher beschreibt,
wobei die von der Reglerstruktur bestimmten Schätzwerte der Kenngrößen die das Ersatzschaltbild kennzeichnenden Kenngrößen sind.

3. Verfahren nach mindestens einem der vorangegangenen Ansprüche,
**dadurch gekennzeichnet, dass**
zur Bestimmung der Kapazität $C_{ges}$

   - die Abweichung multipliziert wird mit dem Vorzeichensignal der erfassten zweiten Größe und
   - das Produkt integriert wird, um den Schätzwert für die Kapazität $C_{ges}$ zu erhalten.

4. Verfahren nach mindestens einem der vorangegangenen Ansprüche,
**dadurch gekennzeichnet, dass**
zur Bestimmung des Gesamtwiderstandes $R_{ges}$,

   - nur wenn die zeitliche Ableitung des erfassten Stromverlaufs einen Mindestwert überschreitet, die Abweichung multipliziert wird mit dem Vorzeichensignal der zeitliche Ableitung des erfassten Stromverlaufs und
   - das Produkt integriert wird, um den Schätzwert für des Gesamtwiderstand $R_{ges}$ zu erhalten.

5. Verfahren nach mindestens einem der vorangegangenen Ansprüche,
**dadurch gekennzeichnet, dass**
der zeitliche Verlauf der Werte einer oder beider erfassten Größen tiefpassgefiltert wird,
wobei die zeitliche Ableitung aus dem tiefpassgefilterten Signal bestimmt wird.

6. Verfahren nach mindestens einem der vorangegangenen Ansprüche,
**dadurch gekennzeichnet, dass**
im Streckenmodell der Schätzwert der zweiten Größe integriert wird und/oder durch beide Kenngrößen dividiert wird.

7. Verfahren nach mindestens einem der vorangegangenen Ansprüche,
**dadurch gekennzeichnet, dass**
die Abweichung einem Begrenzer (4, 5) zugeführt wird.

8. Verfahren nach mindestens einem der vorangegangenen Ansprüche,
**dadurch gekennzeichnet, dass**
die erste Größe der erfasste Strom und die zweite Größe die erfasste Spannung ist oder umgekehrt.

9. Energiespeichersystem zur Durchführung eines Verfahrens nach mindestens einem der vorangegangenen Ansprüche,
**dadurch gekennzeichnet, dass**
Mittel zur Erfassung des Ausgangsstroms (i) und der Ausgangsspannung (u) an einem Energiespeicher vorgesehen sind, so dass die erfassten Größen einer Reglerstruktur und einem Streckenmodell zuführbar sind, und dass ein Regelsystem vorgesehen ist, das aus der Reglerstruktur sowie aus dem Streckenmodell besteht, wobei die Mittel zur Erfassung und das Regelsystem dazu eingerichtet sind, ein Verfahren nach mindestens einem der Ansprüche 1 bis 8 durchzuführen.

10. Energiespeichersystem nach Anspruch 9,
**dadurch gekennzeichnet, dass**
der Energiespeicher aus Kondensatoren zusammengesetzt ist, die in Reihe und/oder parallel miteinander verschaltet sind.


**Claims**

1. Method for determining characteristics of an energy store, wherein the output current (i) and the output voltage (u) of the energy store are detected, that is to say are detected variables, wherein a first of the two detected variables is fed to a plant model, the second of the two detected variables is fed to a controller structure,
wherein the plant model generates a model value for the second variable and this model value is fed to the controller structure, wherein the controller structure determines estimated values of the characteristics, which are specified to the plant model, and wherein in the controller structure the deviation between the model value for the second variable and the detected value of the second variable is determined and the controller structure adjusts the characteristic values in each case to such a value that the deviation disappears,
**characterized in that**
in the controller structure the deviation between the model value for the second variable and the detected value of the second variable is determined and the estimated values of the characteristics are determined as output signal and/or manipulated values of the controller structure as a function of the temporal evolution of the deviation and the temporal evolution of the second variable,
wherein each determination of a characteristic is assigned a path which is different from and independent of the other paths, and
wherein the temporal evolution of the deviation and the temporal evolution of the second variable are fed to each path.

2. Method according to claim 1,
**characterized in that**
the plant model describes an equivalent circuit diagram for the energy store,
wherein the estimated values of the characteristics, which are determined by the controller structure, are the characteristics that characterize the equivalent circuit diagram.

3. Method according to at least one of the preceding claims,
**characterized in that**,
in order to determine the capacitance $C_{ges}$,

     - the deviation is multiplied by the sign signal of the detected second variable and
     - the product is integrated to obtain the estimated value for the capacitance $C_{ges}$.

4. Method according to at least one of the preceding claims,
**characterized in that**,
in order to determine the total resistance $R_{ges}$,

     - only if the time derivative of the detected current curve exceeds a minimum value, the deviation is multiplied by the sign signal of the time derivative of the detected current curve and
     - the product is integrated to obtain the estimated value for the total resistance $R_{ges}$.

5. Method according to at least one of the preceding claims,
**characterized in that**
the temporal evolution of the values of one or both detected variables is low-pass-filtered,
wherein the time derivative is determined from the low-pass-filtered signal.

6. Method according to at least one of the preceding claims,
**characterized in that**
in the plant model the estimated value of the second variable is integrated and/or is divided by both characteristics.

7. Method according to at least one of the preceding claims,
**characterized in that**
the deviation is fed to a limiter (4, 5).

8. Method according to at least one of the preceding claims,
**characterized in that**
the first variable is the detected current and the second variable is the detected voltage, or vice versa.

9. Energy storage system for carrying out a method according to at least one of the preceding claims,
**characterized in that**
means for detecting the output current (i) and the output voltage (u) are provided on an energy store such that the detected variables can be fed to a controller structure and to a plant model, and **in that** a control system is provided which consists of the controller structure and of the plant model,
wherein the means for detecting and the control system are configured to carry out a method according to at least one of claims 1 to 8.

10. Energy storage system according to claim 9,
**characterized in that**
the energy store is composed of capacitors which are connected in series and/or in parallel with one another.

**Revendications**

1. Procédé pour déterminer des grandeurs caractéristiques d'un accumulateur d'énergie,
dans lequel le courant de sortie (i) et la tension de sortie (u) de l'accumulateur d'énergie sont détectés et sont donc des grandeurs détectées,
dans lequel une première des deux grandeurs détectées est amenée à un modèle de système, la deuxième des deux grandeurs détectées est amenée à une structure de régulateur,
dans lequel le modèle de système génère une valeur de modèle pour la deuxième grandeur et cette valeur de modèle est amenée à la structure de régulateur,
dans lequel la structure de régulateur détermine des valeurs estimées des grandeurs caractéristiques qui sont prescrites au modèle de système et
dans lequel l'écart entre la valeur de modèle pour la deuxième grandeur et la valeur détectée de la deuxième grandeur est déterminé dans la structure de régulateur et la structure de régulateur régule les valeurs de grandeurs caractéristiques dans chaque cas à une valeur telle que l'écart disparaît,
**caractérisé en ce que**
l'écart entre la valeur de modèle pour la deuxième grandeur et la valeur détectée de la deuxième grandeur est déterminé dans la structure de régulateur et les valeurs estimées des grandeurs caractéristiques sont déterminées en tant que signal de sortie et/ou valeurs de réglage de la structure de régulateur en fonction de la courbe temporelle de l'écart et de la courbe temporelle de la deuxième grandeur,
dans lequel chaque détermination d'une grandeur caractéristique est associée à un chemin respectif qui est différent et indépendant des autres chemins, et
dans lequel la courbe temporelle de l'écart et la courbe temporelle de la deuxième grandeur sont amenées à chaque chemin.

2. Procédé selon la revendication 1,
**caractérisé en ce que**
le modèle de système décrit un circuit équivalent pour l'accumulateur d'énergie,
dans lequel les valeurs estimées des grandeurs caractéristiques déterminées par la structure de régulateur sont les grandeurs caractéristiques qui caractérisent le circuit équivalent.

3. Procédé selon au moins l'une des revendications précédentes,
**caractérisé en ce que**
pour déterminer la capacité $C_{ges}$,

   - l'écart est multiplié par le signal de signe de la deuxième grandeur détectée et
   - le produit est intégré pour obtenir la valeur estimée de la capacité $C_{ges}$.

4. Procédé selon au moins l'une des revendications précédentes,
**caractérisé en ce que**
pour déterminer la résistance totale $R_{ges}$,

   - seulement si la dérivée par rapport au temps de la courbe de courant détectée dépasse une valeur minimale, l'écart est multiplié par le signal de signe de la dérivée par rapport au temps de la courbe de courant détectée et
   - le produit est intégré pour obtenir la valeur estimée de la résistance totale $R_{ges}$.

5. Procédé selon au moins l'une des revendications précédentes,
**caractérisé en ce que**
la courbe temporelle des valeurs de l'une ou des deux grandeurs détectées est filtrée passe-bas,
dans lequel la dérivée par rapport au temps est déterminée à partir du signal filtré passe-bas.

6. Procédé selon au moins l'une des revendications précédentes,
**caractérisé en ce que**
la valeur estimée de la deuxième grandeur est intégrée dans le modèle de système et/ou divisée par les deux grandeurs caractéristiques.

**7.** Procédé selon au moins l'une des revendications précédentes,
**caractérisé en ce que**
l'écart est amené à un limiteur (4, 5).

**8.** Procédé selon au moins l'une des revendications précédentes,
**caractérisé en ce que**
la première grandeur est le courant détecté et la deuxième grandeur est la tension détectée ou vice versa.

**9.** Système accumulateur d'énergie pour la mise en œuvre d'un procédé selon au moins l'une des revendications précédentes,
**caractérisé en ce que**
des moyens pour détecter le courant de sortie (i) et la tension de sortie (u) sur un accumulateur d'énergie sont prévus de telle sorte que les grandeurs détectées peuvent être amenées à une structure de régulateur et à un modèle de système, et qu'un système de régulation est prévu, qui est constitué de la structure de régulateur et du modèle de système, dans lequel les moyens de détection et le système de régulation sont conçus pour mettre en œuvre un procédé selon au moins l'une des revendications 1 à 8.

**10.** Système accumulateur d'énergie selon la revendication 9,
**caractérisé en ce que**
l'accumulateur d'énergie est composé de condensateurs qui sont connectés en série et/ou en parallèle les uns avec les autres.

Fig.1

EP 2 872 908 B1

Fig.2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011119005
- DE 10301823 A1
- DE 19959019 A1
- WO 2011102472 A1
- EP 2063280 A1
- DE 102009046500 A1
- EP 1480051 A2
- US 20130158916 A1
- WO 2012156233 A2